# EUROPEAN PATENT SPECIFICATION

(11) **EP 0 632 951 B1**
(45) Date of publication and mention of the grant of the patent: **26.06.1996**
(21) Application number: 93906574.4
(22) Date of filing: 17.03.1993
(51) Int. Cl.: H05K 9/00

(54) **ELECTROMAGNETIC SHIELDING DEVICE**
ELEKTROMAGNETISCHE ABSCHIRMUNGSVORRICHTUNG
DISPOSITIF FORMANT UN ECRAN ELECTROMAGNETIQUE

(30) Priority: 27.03.1992 IT MI920729
(43) Date of publication of application: 11.01.1995
(73) Proprietor: ITALTEL SOCIETA ITALIANA TELECOMUNICAZIONI s.p.a., I-20149 Milano (IT)
(72) Inventor: VINCENZI, Tiziano, I-20094 Buccinasco (IT); AIELLO, Sergio, I-20019 Seguro (IT)
(74) Representative: Giustini, Delio
(86) International application number: EP9300680
(87) International publication number: WO9320676

(56) References cited:
- EP-A- 0 425 193
- EP-A- 0 447 942
- WO-A-86/01069
- DE-U- 9 106 955

## Description

### Technical Field

The present invention relates to an electromagnetic shielding device for cabinets of electronic equipment, in particular cubicles, racks, housings and similar, provided with at least one openable element, such as e.g. a shutter, a door, a gate, a covering panel, etc.

Further the invention will be illustrated with reference to a preferred application on cabinets for telecommunication equipment, but this should not be understood in a limiting sense as the invented device can be applied to numerous other equipments where the realization of a shielding against transmitted or received electromagnetic interference is necessary like in portable radio equipment.

### Industrial Applicability

In general this type of devices consists of elastic elements or springs, and such springs are fixed along the edges of the opening destined to be closed by shutters, or more in general the non airtight parts, in order to guarantee the electrical contact between the parts, and consequently an efficient shielding. The dimensions and the number of such devices depend on the characteristics of the required shielding, and, in particular in telecommunication equipment operating at very high frequencies, the number of such devices per length unit is considerable.

### Background Art

Electromagnetic shielding device between parts of housing for electric equipment are already known, which consists of a contact spring with a triangular isosceles profile, which opening corresponds to a summit with at least one in bent flap.

Such spring has to be inserted in such a way that it clasps the edge of one of the housing parts, fitting permanently by means of the flap engaging in an aperture provided in the housing member, and with one leg abutting against the other housing member when this is approached to the previous one.

This known device presents the drawback of the lack of preload and, as a consequence, it is not able to exert a minimum contact force for its total operative arch (of deformation). That's why the contact pressure is inferior to that minimum necessary for an appreciable initial stroke of the complete travel.

DE-U-9 106 955 discloses an electromagnetic shielding device between housing members for electronic equipment comprising a strip of contact springs connected together by weakened portions, each spring having a first leg and a second substantially flat leg shorter than the former, said legs being connected at one of their ends by a curved portion elastically urging the legs one against the other, and suitable to embrace the edge of one of said housing members and being locked thereto thanks to at least one lap formed and bent-in on one of said legs and engaging an opening provided in said embraced housing member.

### Object of the Invention

The object of the present invention is to overcome the disadvantages and limitations illustrated before, and in particular to realize an electromagnetic shielding device which functioning should not be sensible to dimensional variations of the housing members on which it will be mounted, and which total spring modulus should be variable in an extremely easy way at the moment of its manufacturing.

### Disclosure of Invention

According to the inention, these objects are reached through an electromagnetic shielding device between housing members for electronic equipment consisting of a contact spring having a first leg and a second substantially flat leg shorter than the former, said legs being connected at one of their ends by a curved portion elastically urging the legs one against the other, and suitable to embrace the edge of one of said housing members and being locked thereto thanks to at least one lap formed and bent-in on one of said legs and engaging an opening provided in said embraced housing member
characterized by the fact that
said curved portion is a circumference arc extending for more than 180°, and said first leg consists of two aligned flat portions connected by an intermediate deformed part forming a recess for receiving the end of said second leg when the spring is not applied to said housing member.

Additional advantageous characteristics are the subject of the appended claims.

### Brief Description of Drawings

Now the invention will be described referring to the enclosed drawings illustrating preferred but not limiting embodiment of the invention, where:
Fig. 1 illustrates in perspective a preferred embodiment of the spring which constitutes the electromagnetic shielding device according to the present invention;
Fig. 2 is a lateral view of the spring shown in Fig. 1;
Fig. 3 illustrates a spring according to the invention set up on the edge of a sheet metal;
Fig 4 illustrates some springs fixed on an edge of sheet metal;
Fig. 5A and 5B show the functioning of the spring which makes up the electromagnetic shielding device according to the present invention; and
Fig. 6 shows an application of the "deep-set" type of the electromagnetic shielding device according to the present invention.

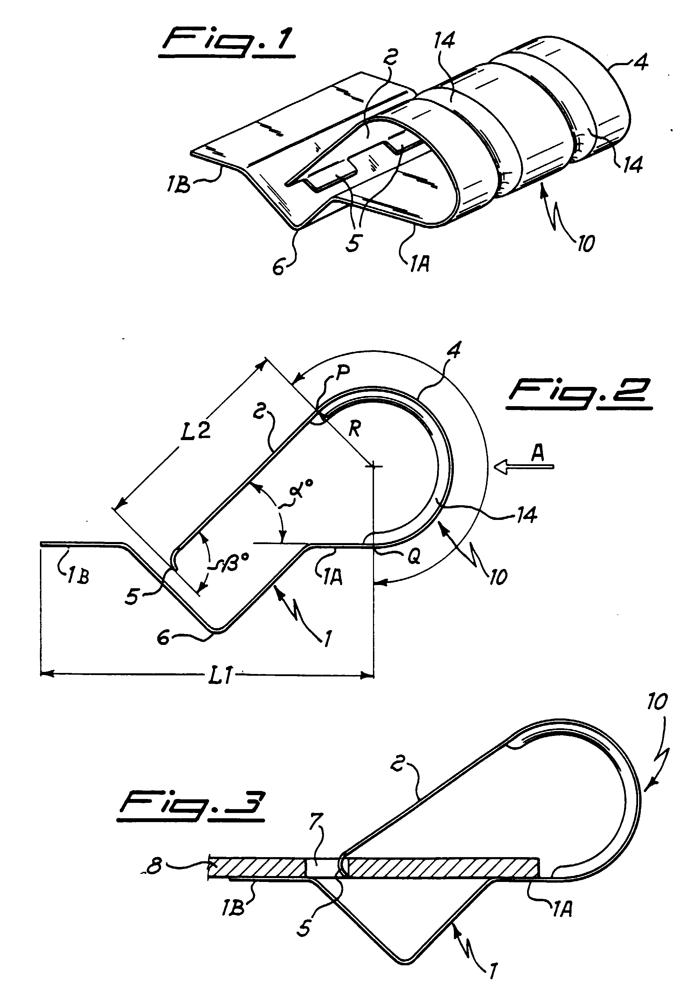

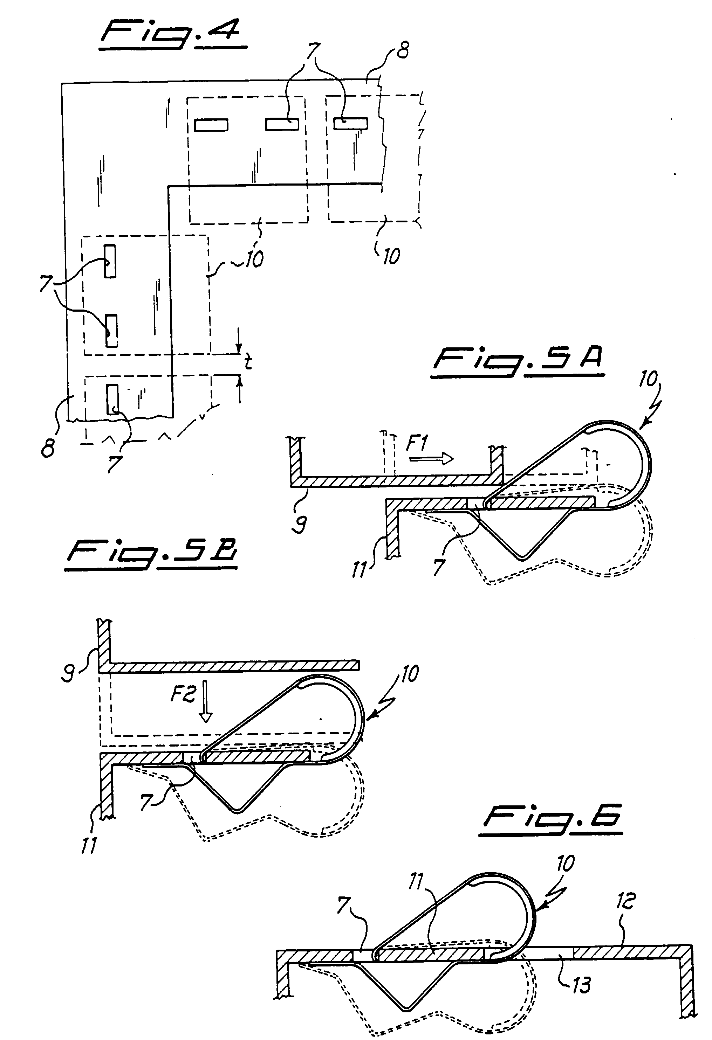

Referring in particular to figures 1 and 2, the electromagnetic shielding device according to the invention is made up by a spring 10, in lead material, including one major leg 1 provided with a strain forming a recess 6 and with a total length L1, one leg substantially flat 2 with a length L2 inferior to L1, and a curved junction portion shaped like a circumference arc with a radius R.

Spring 10 is obtained by the strain of a metallic foil, for example of steel.

The free edge of the short leg 2 ends in 2 flaps 5 made up by shearing and inside bending and which abut when the spring is at rest inside of recess 6 of the long leg 1.

As shown in figures 1 and 2 the strain of the major side is preferably obtained by three bendings of the metallic foil which form a V-shape portion between the initial stroke 1A and the final one 1B of leg 1 which substantially lie on the same plane. Between this plane, considered as the plane of leg 1, and the plane which contains substantially leg 2, an angle α is differentiated (when at rest).

The two legs of the spring are linked to portion 4 in such a way that they turn out to be tangents to the circumference in the transition point (points P and Q in figure 2).

Referring in particular to Fig. 2, the curved portion 4 extends for a circumference arc A of more than 180°, and by preference between 220° and 250°. The angle α formed between the legs 1 and 2 is between 35° and 60°, while the angle β formed between the flaps 5 and leg 2 is between 70° and 100°.

The difference of length (L1 - L2) between the legs 1 and 2 is at least equal to 20% of the long leg 1. The characteristics of the elastic yielding of the spring depend to a good extend on the length of the major leg 1 or on the relation between the length of both legs, and therefore, varying the extension of such leg it is possible to adjust easily and quickly the characteristics of the spring according to the needs of application. Such modification can be realized the manufacturing, or even at the moment of installation (by shortening part 1B), and preferably based on previously prepared tables which link the length of leg 1 to the thickness of the part on which the spring will be applied, and even to other geometric parameters of the housing.

Preferably as shown in figures 1 and 2, there have been created two ribs 14 on the circumference arc 4, which are obtained during the pressing of the spring, by deforming towards the inner side of the arc two circumference stripes. Such ribs oppose the elastic return of the material and assure the wanted inclination of leg 2 referring to leg 1 (angle α).

As shown in figures 1 and 2, when the spring is at rest and not applied to the edge of a component to be shielded, it has a rest configuration, in which flap 5 is seated in recess 6, getting in this way the settled preload whenever the spring is fitted on the housing edge. This preload has to be determined in a way to assure the minimum electric contact between the parts as soon as the spring is stressed and leg 1 is detached from the edge, as shown in details in figures 5 and 6. In this way we get the maximum usable work space of the spring, which is equal to the internal diameter of the curved part 4 less the thickness of the housing edge. Besides this the ribs 14 make the spring more rigid in order to prevent it from opening and losing so the preload, when the fixing tool is taken away.

The figures 3 and 4 show the application of some springs according to the invention to the metallic wall of a housing member 8. More precisely figure 4 is the view from above of some springs 10 mounted on a sheet metal edge 8, and figure 3 shows at an enlarged scale and in profile a spring applied to a housing edge 8.

Referring in particular to figure 3 the housing member 8 is provided with an aperture 7 in which the flaps 5 of the short leg enter so that the spring gets blocked in the wanted position, while the parts 1A and 1B of the long leg 1 remain adherent to wall 8 under the condition of an applied but not stressed spring. The distance t between two adjacent springs (see figure 4) depends on the frequency the shielding effect is wanted for.

The figures 5A and 5B show the functioning of the spring according to the invention shown when applied to a wall 11 with two different types of closure. In the rest position, that means when the cabinet is open, the configuration of the spring is indicated by a solid line design. When one of the doors, a mobile shutter or a wall 9, will be closed by a movement in the direction of arrow F1 or F2, the spring assumes the configuration shown by a broken line, with the short leg lying down on the housing wall 11 and the long leg 1 drawing away from it revolving with respect to such edge. As shown in the figure also the free end of leg 1 changes position compared to that before the closure.

Thanks to the configuration of the spring according to the invention, this cannot be deformed accidentally beyond the elastic field while engaged, as the same housing edge on which it is fixed acts as a retainer.

Figure 6 shows an application of the re-entrant type of spring according to the invention. The spring according to the invention is set up in such a way that it abuts an internal portion of wall 12, thanks to a gate or slit 13 created in an internal position and withdrawn with respect to the positioning apertures 7. The functioning of the spring illustrated in broken lines is analogous to that of the previous figures 5A and 5B.

The dimensions of the spring according to the invention vary in function of the housings dimensions they are assigned to, of the electromagnetic frequencies to be shielded and of the used materials. For the protection of telecommunication equipment the spring should be approximately 10 - 20 mm long and about 0.10 - 0.30 mm thick using austenitic steel NiCr.
Although the invention has been illustrated referring to a particular case, it can be applied in general to other housing structures, as the technician experienced in the field know.

## Claims

1. Electromagnetic shielding device between housing members for electronic equipment consisting of a contact spring (10) having a first leg (1) and a second substantially flat leg (2) shorter than the former, said legs (1, 2) being connected at one of their ends by a curved portion (4) elastically urging the legs one against the other, and suitable to embrace the edge (8, 11, 12) of one of said housing members and being locked thereto thanks to at least one lap (5) formed and bent-in on one (2) of said legs and engaging an opening (7) provided in said embraced housing member (8, 11, 12),
characterized by the fact that
said curved portion (4) is a circumference arc (A) extending for more than 180°, and said first leg (1) consists of two aligned flat portions (1A, 1B) connected by an intermediate deformed part forming a recess (6) for receiving the end of said second leg (2) when the spring (10) is not applied to said housing member (8, 11, 12).

2. Electromagnetic shielding device according to claim 1, characterized by the fact that said at least one lap (5) is bent-in on the end of said second leg not connected to the curved portion.

3. Electromagnetic shielding device according to claim 1, characterized by the fact that said recess (6) is a V-shaped recess obtained through folding the intermediate portion of said first leg (1).

4. Electromagnetic shielding device according to the previous claims, characterized by the fact that the circumference ribs (14) are formed in said curved portion (4) by buckling two circumferential strips of the spring (10) towards the inner side of said arc.

5. Electromagnetic shielding device according to claim 1, characterized by the fact that the difference in length (L1 - L2) between said legs (1, 2) is at least equal to 20% of the length of said first leg (1).

6. Electromagnetic shielding device according to claim 1, characterized by the fact that the angular extension of said circumference arc (A) is comprised between 220° and 250°.

7. Electromagnetic shielding device according to claim 1, characterized by the fact that said legs (1, 2) are substantially tangents to said circumference arc (A).

8. Electromagnetic shielding device according to the previous claims, characterized by the fact that the plane containing said second leg (2) is inclined by an angle (α) comprised between 35° and 60° with respect to a plane containing said aligned flat portions (1A, 1B).

9. Electromagnetic shielding device according to claims 1 and 2, characterized by the fact that said at least one lap (5) is bent-in to the second leg (2) according to an angle (β) comprised between 70° and 100°.

## Patentansprüche

1. Elektromagnetische Abschirmungsvorrichtung zwischen Gehäusebauelementen für elektronische Ausrüstung, bestehend aus einer Kontaktfeder (10) mit einem ersten Schenkel (1) und einem zweiten im wesentlichen flachen Schenkel, welcher kürzer als der erste ist, wobei die genannten Schenkel (1, 2) an einem ihrer Enden durch ein gebogenes Teilstück verbunden sind, welches die Schenkel elastisch gegeneinander drückt, und die genannte Vorrichtung ist geeignet, die Kanten (8, 11, 12) eines der genannten Gehäusebauteile zu umklammern, und sie ist mit diesem dank mindestens einer Zunge (5) fest verbunden, welche auf einem der genannten Schenkel (2) geformt und nach innen gebogen ist und in eine im genannten Gehäusebauteil (8, 11, 12) vorgesehene Öffnung (7) eingreift,
dadurch gekennzeichnet, daß
das genannte gebogene Teilstück (4) ein mehr als 180° umfassender Kreisbogen ist, und der genannte erste Schenkel (1) besteht aus zwei ausgerichteten flachen Teilstücken (1A, 1B), die durch ein deformiertes Zwischenstück verbunden sind, welches eine Vertiefung (6) zur Aufnahme des Endes des genannten zweiten Schenkels (2) bildet, wenn die Feder (10) nicht an dem genannten Gehäusebauteil (8, 11, 12) angebracht ist.

2. Elektromagnetische Abschirmungsvorrichtung nach Anspruch 1, dadurch gekennzeichnet, daß die genannte mindestens eine Zunge (5) auf dem Ende des genannten zweiten Schenkels, welcher nicht mit dem gebogenen Teilstück verbunden ist, nach innen gebogen ist.

3. Elektromagnetische Abschirmungsvorrichtung nach Anspruch 1, dadurch gekennzeichnet, daß die genannte Vertiefung (6) eine v-förmige Vertiefung ist, die man durch falten des Zwischenteils des genannten ersten Schenkels (1) erhält.

4. Elektromagnetische Abschirmungsvorrichtung entsprechend den voraufgegangenen Ansprüchen, dadurch gekennzeichnet, daß die kreislinienartigen Versteifungsrippen (14) im genannten gebogenen Teilstück durch einknicken zweier kreislinienartiger Streifen der Feder (10) in Richtung der inneren Seite des genannten Bogens gebildet werden.

5. Elektromagnetische Abschirmungsvorrichtung nach Anspruch 1, dadurch gekennzeichnet, daß der Längenunterschied (L1 - L2) zwischen den Schenkeln (1, 2) mindestens 20% der Länge des genannten ersten Schenkels ausmacht.

6. Elektromagnetische Abschirmungsvorrichtung nach Anspruch 1, dadurch gekennzeichnet, daß die Größe des Winkels des genannten kreislinienartigen Bogens (A) zwischen 220° und 250° ausmacht.

7. Elektromagnetische Abschirmungsvorrichtung nach Anspruch 1, dadurch gekennzeichnet, daß die genannten Schenkel (1, 2) im wesentlichen Tangenten des genannten kreislinienartigen Bogens (A) sind.

8. Elektromagnetische Abschirmungsvorrichtung entsprechend den voraufgegangenen Ansprüchen, dadurch gekennzeichnet, daß die Fläche, welche den genannten zweiten Schenkel (2) einschließt, in einem Winkel (α) zwischen 35° und 60° im Vergleich zu einer Ebene, welche die genannten ausgerichteten flachen Abschnitte (1A, 1B) einschließt, steht.

9. Elektromagnetische Abschirmungsvorrichtung entsprechend den Ansprüchen 1 und 2, dadurch gekennzeichnet, daß die genannte mindestens eine Zunge (5) gegen den zweiten Schenkel (2) entsprechend einem Winkel (β) in der Größenordnung zwischen 70° und 100° gebogen ist.

## Revendications

1. Dispositif formant un écran électromagnétique entre des parts de logement pour équipement électronique consistant en un ressort de contact (10) ayant une première jambe (1) et une deuxième jambe substantiellement plate (2), qui è plus courte que la première, les dites jambes (1, 2) étant reliées à une de leurs extrémités par une portion courbée (4), qui presse de manière élastique le jambes l'une contre l'autre, et le dit dispositif est apte à embrasser le bord (8, 11, 12) d'une des parts du dit logement et il est positionné de manière permanente à cette part grâce à au moins une languette (5) formée et pliée vers l'intérieur sur une (2) des dites jambes et la dite languette s'enfile dans une ouverture (7) prévue dans la dite part embrassée du logement (8, 11, 12),
caractérisé en ce que
la dite portion courbée (4) est un arc de circonférence (A) de plus de 180°, et la dite première jambe (1) consiste en deux portions plates alignées (1A, 1B) reliées par une part intermédiaire déformée pour former un renfoncement (6) pour recevoir l'extrémité de la dite deuxième jambe (2), quand le ressort (10) n'est pas appliqué à la dite part de logement (8, 11, 12).

2. Dispositif formant un écran électromagnétique selon la revendication 1, caractérisé en ce que la dite au moins une languette (5) est repliée sur l'extrémité de la dite deuxième jambe non reliée à la portion courbée.

3. Dispositif formant un écran électromagnétique selon la revendication 1, caractérisé en ce que le dit renfoncement (6) est un renfoncement à forme de V obtenu par un pliage de la portion intermédiaire de la dite première jambe (1).

4. Dispositif formant un écran électromagnétique selon les revendications précédentes, caractérisé en ce que les nervures circonférentielles (14) sont formées dans la dite portion courbée (4) par la déformation de deux lignes du ressort (10) vers le coté intérieur du dit arc.

5. Dispositif formant un écran électromagnétique selon la revendication 1, caractérisé en ce que la différence de longueur (L1 - L2) entre les dites jambes (1, 2) correspond au moins égal à 20% de la longueur de la dite première jambe (1).

6. Dispositif formant un écran électromagnétique selon la revendication 1, caractérisé en ce que le dit arc de circonférence (A) est compris entre 220° et 250°.

7. Dispositif formant un écran électromagnétique selon la revendication 1, caractérisé en ce que les dites jambes (1, 2) sont substantiellement tangentes au dit arc de circonférence (4).

8. Dispositif formant un écran électromagnétique selon les revendications précédentes, caractérisé en ce que la surface plane contenant la dite deuxième jambe (2) est inclinée par un angle compris entre 35° et 60° par rapport à la surface plane contenant les dites portions planes alignées (1A, 1B).

9. Dispositif formant un écran électromagnétique selon les revendications 1 et 2, caractérisé en ce que la dite au moins une languette (5) est repliée vers la deuxième jambe (2) selon un angle (β) compris entre 70° et 100°.
